# EUROPÄISCHE PATENTSCHRIFT

(11) **EP 1 886 357 B1**
(45) Veröffentlichungstag und Bekanntmachung des Hinweises auf die Patenterteilung: **29.02.2012**
(21) Anmeldenummer: 06763446.9
(22) Anmeldetag: 01.06.2006
(51) Int. Cl.: H01L 31/02, H01L 31/18

(54) **VERFAHREN ZUR FÜHRUNG VON KONTAKTBÄNDERN BEI SOLARMODULEN UND SOLARMODUL**
METHOD FOR GUIDING CONTACT STRIPS ON SOLAR MODULES AND A SOLAR MODULE
PROCEDE DE GUIDAGE DE BANDES DE CONTACT DANS DES MODULES SOLAIRES ET MODULE SOLAIRE

(30) Priorität: 01.06.2005 DE 102005026132
(43) Veröffentlichungstag der Anmeldung: 13.02.2008
(73) Patentinhaber: Sulfurcell Solartechnik GmbH, 12489 Berlin (DE)
(72) Erfinder: RÜHLE, Ulfert, 14532 Kleinmachnow (DE); EISELE, Wolfgang, 10407 Berlin (DE); SAATCI, Gürol, 12107 Berlin (DE)
(74) Vertreter: Hengelhaupt, Jürgen
(86) Internationale Anmeldenummer: PCT/EP2006/062822
(87) Internationale Veröffentlichungsnummer: WO 2007/009837

(56) Entgegenhaltungen:
- US-A- 5 733 382
- PATENT ABSTRACTS OF JAPAN Bd. 2000, Nr. 03, 30. März 2000 (2000-03-30) -& JP 11 354822 A (SANYO ELECTRIC CO LTD), 24. Dezember 1999 (1999-12-24)

## Beschreibung

Die Erfindung betrifft ein Verfahren zur Führung von Kontaktbändern bei Solarmodulen, die aus einem Laminat einer lichtzugewandten Glasscheibe und einer lichtabgewandten Glasscheibe bestehen, sowie ein nach dem Verfahren hergestelltes laminiertes Solarmodul, dessen photovoltaisch aktive Schicht zwischen den Glasscheiben mit Kontaktbändern elektrisch leitend verbunden ist.

Kontaktbänder, die in Solarmodulen den generierten Strom sammeln, müssen auf die lichtabgewandete (Rück-)Seite des Moduls geführt und dort in eine Kontaktbox geleitet werden.

Die Solarmodule sind als Glas-Glas-Laminate ausgeführt, wobei die photovoltaisch aktiven Materialien entweder Dünnschichthalbleiter oder Siliziumwafer sein können. In jedem Fall wird der photovoltaisch erzeugte Strom durch Kontaktbänder von der beleuchteten Seite des Moduls auf die lichtabgewandte Seite geführt, um dort in einer Kontaktbox mit externen Kontakten verbunden zu werden.

Die folgenden Randbedingungen müssen bei der Führung der Kontaktbänder außerhalb des laminierten Modulbereichs beachtet werden:
- Die Kontaktbänder müssen langfristig gegen Korrosion und andere Umwelteinflüsse geschützt werden.
- Die Kontaktbänder müssen hochspannungsfest gegen Eintrag elektrischer Spannung von außen (zum Beispiel über einen Rahmen) versiegelt sein.

Bekannt ist die Herstellung eines Moduls mit Löchern in der lichtabgewandten Glasscheibe, durch die die Kontaktbänder hindurchgeführt, mit der Kontaktbox verbunden und dann versiegelt werden (DE 102 25 140 A1). Nachteilig ist der hohe technologische Aufwand für das nachträgliche Bohren der Durchgangslöcher und das Herstellen der leitenden Verbindungen.

Eine andere Art der Herstellung ist, eine Glasscheibe auf der lichtabgewandten Seite einzusetzen, die geringere Außenmaße als das Gegenstück auf der lichtzugewandten Seite aufweist. Die kleinere Scheibe wird dann zentrisch auf die größere Scheibe lamininiert, wobei die gesamte Rückseite bis hin zu den Außenkanten der größeren Glasscheibe mit einem entsprechend isolierenden Material, zum Beispiel Tedlar, zusätzlich versiegelt wird. Die Kontaktbänder werden in diesem Fall zwischen der Unterseite der unteren Glasscheibe und dem isolierenden Material bis zur Position der Kontaktbox und dort durch einen Einschnitt im isolierenden Material auf die Außenseite des Moduls geführt, um dann mit der Kontaktbox verbunden zu werden ("CIS Thin Film Manufacturing at Shell Solar: Practical Techniques in Volume Manufacturing", Wieting et al., Proceedings of the 31st IEEE PV-Specialists Conference, Orlando, FL, 2005).

Nach einer weiteren Methode wird zusätzlich zu den Glasscheiben noch eine geeignete elektrische Platine in den Laminataufbau integriert, an der die Kontaktbänder im Inneren des Laminats angebracht werden. Die Platine verfügt über entsprechende Durchkontaktierungen, die das Anbringen und Kontaktieren der Kontaktbox auf der Außenseite ermöglichen (a.a.O.).

Nachteilig bei den zuletzt genannten beiden Verfahren ist ebenfalls der hohe technologische Aufwand, der entweder durch die Bereitstellung der verschieden großen Glasscheiben und die gesamte Versiegelung der Rückseite oder durch die zusätzliche Platine und deren Einbindung in das gesamte Laminat entsteht.

In der Dokumenten US 5 733 382 und JP11 354 822 werden isolierte Drähte um die Kanten der Richtabgewandten Glasscheibe herumgeführt.

Der Erfindung liegt die Aufgabe zugrunde, ein technologisch einfaches Verfahren zur Führung der Kontaktbänder und ein entsprechendes Solarmodul anzugeben.

Erfindungsgemäß wird die Aufgabe gelöst durch die Merkmale der Ansprüche 1 und 5. Zweckmäßige Ausgestaltungen sind Gegenstand der Unteransprüche.

Danach werden
- die Kontaktbänder von der Oberseite der lichtabgewandten Glasscheibe um die Kanten dieser Glasscheibe herumgeführt,
- bis auf die Unterseite dieser Glasscheibe mit einem Laminiermedium und bis mindestens über die obere Kante dieser Glasscheibe mit einer Isolierfolie abgedeckt
- und zum Laminieren der beiden Glasscheiben in dieser Stellung gehalten.

Ein nach dem Verfahren hergestelltes Solarmodul weist dann einen Randbereich auf, bei dem die Kontaktbänder von der Oberseite der lichtabgewandten Glasscheibe um die Kanten dieser Glasscheibe herumgeführt und bis auf die Unterseite dieser Glasscheibe mit einem Laminiermedium und bis mindestens über die obere Kante dieser Glasscheibe mit einer Isolierfolie abgedeckt sind.

Die Erfindung beruht darauf, dass die Kontaktbänder an einer Seite des Moduls zwischen den beiden Glasscheiben herausgeführt werden. Bis zur Glaskante sind die Kontaktbänder vom Laminiermedium, zum Beispiel EVA, umgeben. An der Glaskante werden die Kontaktbänder umgebogen und auf die Rückseite der lichtabgewandten Glasscheibe geführt. Für den Verarbeitungsprozess können die Kontaktbänder dort temporär fixiert werden, um die weitere Verarbeitung zu vereinfachen.

Zum Schutz der Kontaktbänder vor Umwelteinflüssen und Hochspannung wird nun ein passendes Stück Isolationsfolie und Laminiermedium über das Kontaktband gelegt und ebenfalls temporär fixiert, um den Aufbau gegen Verrutschen vor dem eigentlichen Laminierungsprozess zu sichern. Der gesamte Aufbau wird dann einem in der Industrie üblichen Laminierungsprozess unterzogen, um die beiden Gläser permanent miteinander zu verbinden. Durch das Aufbringen des Laminiermediums zwischen Isolationsfolie und Glas werden die Kontaktbänder permanent an ihrer Position fixiert und die temporären Sicherungen können nun entfernt werden.

Nach der Laminierung können die Kontaktbänder mit der Kontaktbox verbunden werden.

Die Kontaktbänder werden an der Unterseite der lichtabgewandten Glasscheibe entweder durch einen Einschnitt in der Isolationsfolie auf die Außenseite der Folie und in die Kontaktbox geführt und diese auf der Isolationsfolie oder überlappend auf der Glasscheibe und der Isolationsfolie fixiert oder die Kontaktbänder treten am Ende der Isolationsfolie hervor, werden in die Kontaktbox geführt und diese direkt auf der Glasscheibe oder überlappend auf der Glasscheibe und der Isolationsfolie fixiert.

Die Isolationsfolie kann auf unterschiedliche Arten auf der lichtzugewandten Seite des Moduls fixiert werden:
- Eine erste Möglichkeit ist, die Folie von der Unterseite, senkrecht über die Kanten beider Gläser bis auf die Oberseite des lichtzugewandten Glases zu führen und auf der ganzen Strecke Laminiermedium einzusetzen und die Folie so zu fixieren.
- Eine zweite Möglichkeit ist, die Folie von der Unterseite, senkrecht über die Kante des unteren Glases, auf die Oberseite des unteren Glases zu führen und Folie sowie Kontaktbänder mit Hilfe des Laminiermediums mit der Unterseite des lichtzugewandten Glases zu verbinden und so zu fixieren.
- Eine dritte Möglichkeit ist, die Folie von der Unterseite bis zur oberen Kante der lichtzugewandten Glasscheibe zu führen und mit Hilfe des Laminiermediums auf den Glaskanten des oberen und unteren Glases zu fixieren.

Die Folie wird in allen Fällen so angebracht, dass die Kontaktbänder zwischen Folie und Glas verlaufen.

Die Führung der mindestens zwei Kontaktbänder für die Stromhin- und -rückführung kann ebenfalls auf unterschiedliche Arten erfolgen:
- Eine erste Möglichkeit ist, die Kontaktbänder auf der Oberseite des lichtabgewandten Glases an eine gemeinsame Stelle, zum Beispiel in die Mitte der kürzeren Seite der Glasscheiben, zu führen, wo beide Kontaktbänder parallel, ohne sich zu berühren, zwischen den beiden Glasscheiben herausgeführt und um die lichtabgewandte Glasscheibe zur Rückseite gebogen werden.
- Eine zweite Möglichkeit ist, die Kontaktbänder getrennt an unterschiedlichen Stellen zwischen den Glasscheiben austreten zu lassen, auf die Rückseite zu biegen und auf der Modulrückseite, verborgen und geschützt von der Isolationsfolie, in die Kontaktbox zu führen.
- Eine dritte Möglichkeit ist, die Kontaktbänder an unterschiedlichen Stellen zwischen den Glasscheiben austreten zu lassen, auf die Rückseite zu biegen und diese dann auf der Modulrückseite, verborgen und geschützt von der Isolationsfolie, in zwei getrennte Kontaktboxen zu führen.

Die Erfindung soll nachstehend anhand von zwei Ausführungsbeispielen näher erläutert werden. In den zugehörigen Zeichnungen zeigen
- Figur 1: schematisch eine erste Variante der erfindungsgemäßen Kontaktführung und
- Figur 2: schematisch eine weitere Variante.

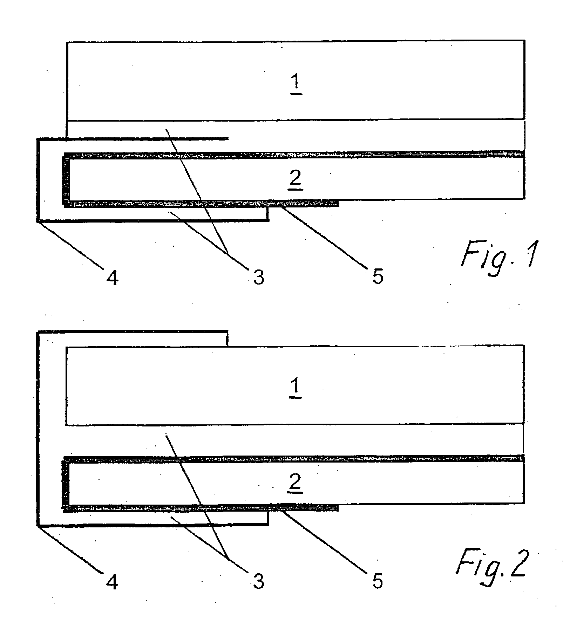

Figur 1 zeigt den Randbereich eines Solarmoduls mit einer photoelektrisch aktiven Substratglasscheibe 2 und einer Abdeckscheibe 1. Von der Oberseite der Substratglasscheibe 2 ist der generierte Strom über Kontaktbänder 5, die leitend mit den Enden der Kontaktbahnen auf der photoelektrisch aktiven Beschichtung der Substratglasscheibe 2 verklebt sind, auf die Rückseite der Substratglasscheibe 2 zu einer (hier nicht gezeigten) Kontaktbox zu führen.

Die Kontaktbänder 5 werden um die Kanten der Substratglasscheibe 2 herumgelegt und dort vorläufig fixiert. Anschließend wird ein Laminiermedium 3, zum Beispiel eine EVA-Folie, auf die Substratglasscheibe 2 so aufgebracht, dass es über die Glaskante übersteht. Nach dem Auflegen der Abdeckscheibe 1 wird dieses überstehende Laminiermedium 3 um die Kanten sowohl der Abdeckscheibe 1 als auch um die der Substratglasscheibe 2 herumgebogen und im Bereich der Kontaktbänder 5 mit einer Isolierfolie 4 abgedeckt, die im hier gezeigten Fall wie das Laminiermedium 3 bis auf die Oberseite der Abdeckscheibe 1 geführt wird. Laminiermedium 3 und Isolierfolie 4 werden wiederum vorläufig fixiert. An der Unterseite der Substratglasscheibe 2 enden die Isolierfolie 4 und das Laminiermedium 3 vor dem Ende der Kontaktbahnen 5, so dass diese hervortreten und dort später in eine Kontaktbox geführt werden können.

Das Solarmodul wird dann in üblicher Weise einer Wärmebehandlung unter Vakuum unterzogen, bei der alle Elemente fest miteinander laminiert werden. Nach dem Laminieren wird das Glas-Glas-Laminat in einen Profilrahmen eingespannt.

Figur 2 zeigt eine Variante bezüglich der Führung der Isolierfolie 4, die in diesem Fall nicht um die Abdeckscheibe 1, sondern um die Kanten der Substratglasscheibe 2 herumgeführt wurde bis auf deren Oberseite, bevor die Substratglasscheibe 2 mit der Abdeckscheibe 1 abgedeckt wurde.

## Patentansprüche

1. Verfahren zur Führung von Kontaktbändern bei Solarmodulen, die aus einem Laminat einer lichtzugewandten Glasscheibe und einer lichtabgewandten Glasscheibe bestehen,
**dadurch gekennzeichnet, dass**
- die Kontaktbänder von der Oberseite der lichtabgewandten Glasscheibe um die Kanten dieser Glasscheibe herumgeführt werden,
- bis auf die Unterseite dieser Glasscheibe mit einem Laminiermedium und bis mindestens über die obere Kante dieser Glasscheibe mit einer Isolierfolie abgedeckt werden
- und zum Laminieren der beiden Glasscheiben in dieser Stellung gehalten werden.

2. Verfahren nach Anspruch 1, **dadurch gekennzeichnet, dass** die Isolierfolie bis auf die Oberseite der lichtzugewandten Glasscheibe geführt wird.

3. Verfahren nach Anspruch 1, **dadurch gekennzeichnet, dass** die Isolierfolie bis auf die Oberseite der lichtabgewandten Glasscheibe geführt wird.

4. Verfahren nach Anspruch 1, **dadurch gekennzeichnet, dass** die Isolierfolie bis an die obere Kante der lichtzugewandten Glasscheibe geführt wird.

5. Solarmodul, das aus einem Laminat einer lichtzugewandten Glasscheibe (1) und einer lichtabgewandten Glasscheibe (2) besteht und dessen photovoltaisch aktive Schicht zwischen den Glasscheiben (1, 2) mit Kontaktbändern (5) elektrisch leitend verbunden ist,
**dadurch gekennzeichnet, dass**
die Kontaktbänder (5) von der Oberseite der lichtabgewandten Glasscheibe (2) um die Kanten dieser Glasscheibe (2) herumgeführt und bis auf die Unterseite dieser Glasscheibe (2) mit einem Laminiermedium (3) und bis mindestens über die obere Kante dieser Glasscheibe (2) mit einer Isolierfolie (4) abgedeckt sind.

6. Solarmodul nach Anspruch 5, **dadurch gekennzeichnet, dass** die Isolierfolie (4) bis auf die Oberseite der lichtzugewandten Glasscheibe (1) geführt ist.

7. Solarmodul nach Anspruch 5, **dadurch gekennzeichnet, dass** die Isolierfolie (4) bis auf die Oberseite der lichtabgewandten Glasscheibe (1) geführt ist.

8. Solarmodul nasch Anspruch 5, **dadurch gekennzeichnet, dass** die Isolierfolie bis an die obere Kante der lichtzugewandten Glasscheibe geführt ist.

## Claims

1. Method for guiding contact strips on solar modules that consist of a laminate of a glass plate facing towards the light and of a glass plate facing away from the light,
**characterised in that**
- the contact strips are guided from the upper side of the glass plate facing away from the light around the edges of this glass plate,
- are covered with a laminating medium to the underside of this glass plate and with an insulating foil to at least over the upper edge of this glass plate,
- and are held in this position for laminating the two glass plates.

2. Method according to claim 1, **characterised in that** the insulating foil is guided to the upper side of the glass plate facing towards the light.

3. Method according to claim 1, **characterised in that** the insulating foil is guided to the upper side of the glass plate facing away from the light.

4. Method according to claim 1, **characterised in that** the insulating foil is guided to the upper edge of the glass plate facing towards the light.

5. Solar module that consists of a laminate of a glass plate (1) facing towards the light and of a glass plate (2) facing away from the light, and the photovoltaic active layer of which between the glass plates (1, 2) is connected to contact strips (5) in an electrically conductive manner,
**characterised in that**
the contact strips (5) are guided from the upper side of the glass plate (2) facing away from the light around the edges of this glass plate (2) and are covered with a laminating medium (3) to the underside of this glass plate (2) and with an insulating foil (4) to at least over the upper edge of this glass plate (2).

6. Solar module according to claim 5, **characterised in that** the insulating foil (4) is guided to the upper side of the glass plate (1) facing towards the light.

7. Solar module according to claim 5, **characterised in that** the insulating foil (4) is guided to the upper side of the glass plate (1) facing away from the light.

8. Solar module according to claim 5, **characterised in that** the insulating foil is guided to the upper edge of the glass plate facing towards the light.

## Revendications

1. Procédé de guidage de bandes de contact dans des modules solaires constitués d'un stratifié d'une plaque de verre tournée vers la lumière et d'une plaque de verre détournée de la lumière,
**caractérisé en ce que**
- les bandes de contact sont guidées autour les bords de la plaque de verre détournée de la lumière, à partir de la face supérieure de cette plaque de verre,
- elles sont recouvertes d'un milieu pour stratifiés jusqu'à la face inférieure de cette plaque de verre, et d'une feuille isolante jusqu'au moins par-dessus le bord supérieur de cette plaque de verre,
- et qu'elles sont maintenues dans cette position pour stratifier les deux plaques de verre.

2. Procédé selon la revendication 1, **caractérisé en ce que** la feuille isolante est guidée jusqu'à la face supérieure de la plaque de verre tournée vers la lumière.

3. Procédé selon la revendication 1, **caractérisé en ce que** la feuille isolante est guidée jusqu'à la face supérieure de la plaque de verre détournée de la lumière.

4. Procédé selon la revendication 1, **caractérisé en ce que** la feuille isolante est guidée jusqu'au bord supérieur de la plaque de verre tournée vers la lumière.

5. Module solaire constitué d'un stratifié d'une plaque (1) de verre tournée vers la lumière et d'une plaque (2) de verre détournée de la lumière, la couche à activité photovoltaïque du module solaire étant reliée à des bandes (5) de contact entre les plaques (1, 2) de verre de façon électriquement conductrice,
**caractérisé en ce que**
les bandes (5) de contact sont guidées autour les bords de la plaque (2) de verre détournée de la lumière, à partir de la face supérieure de cette plaque (2) de verre, et qu'elles sont recouvertes d'un milieu (3) pour stratifiés jusqu'à la face inférieure de cette plaque (2) de verre, et d'une feuille (4) isolante jusqu'au moins par-dessus le bord supérieur de cette plaque (2) de verre.

6. Module solaire selon la revendication 5, **caractérisé en ce que** la feuille (4) isolante est guidée jusqu'à la face supérieure de la plaque (1) de verre tournée vers la lumière.

7. Module solaire selon la revendication 5, **caractérisé en ce que** la feuille (4) isolante est guidée jusqu'à la face supérieure de la plaque (1) de verre détournée de la lumière.

8. Module solaire selon la revendication 5, **caractérisé en ce que** la feuille isolante est guidée jusqu'au bord supérieur de la plaque de verre tournée vers la lumière.
